# EUROPEAN PATENT APPLICATION

(11) **EP 4 835 032 A1**
(43) Date of publication of application: **04.11.2026**
(21) Application number: 24912235.9
(22) Date of filing: 03.12.2024
(51) Int. Cl.: C09J 179/02, B32B 7/12, B32B 7/025, B32B 15/08, B32B 27/06, C09J 11/06, H05K 1/03

(54) **ADHESIVE FOR RESIN MATERIAL HAVING LOW DIELECTRIC PROPERTIES, AND LAMINATE**

(30) Priority: 27.12.2023 JP 2023221756
(71) Applicant: Nihon Parkerizing Co., Ltd., Tokyo 103-0027 (JP)
(72) Inventor: NAKAHARA, Takahiro, Tokyo 103-0027 (JP); IZUMI, Mayuko, Tokyo 103-0027 (JP)
(74) Representative: Arnold & Siedsma
(86) International application number: PCT/JP2024/042757
(87) International publication number: WO 2025/142345

(57) **Abstract**

An adhesive for resin material having low dielectric properties that exhibits excellent adhesion between metal materials (particularly metal materials with low surface roughness) and low dielectric resin materials is provided. An adhesive for adhering a metal material and a low dielectric resin material, the adhesive including an organic amine compound (A) as a main component, wherein the organic amine compound (A) includes at least one selected from a compound (B) having an amino group directly bonded to a nitrogen-containing aromatic ring and a compound (C) having a polyallylamine skeleton.

## Description

### 1. FIELD OF THE INVENTION

The present invention is related to an adhesive for resin material having low dielectric properties, and a laminate.

### 2. BACKGROUND OF THE INVENTION

Metal-clad laminates are made by laminating a metal material (such as copper foil or copper alloy foil) on one or both sides of a resin material (such as a prepreg, which is a composite material of an organic compound and an inorganic compound, or a resin film), and are widely used in the manufacture of printed wiring boards and the like.

The surface of the metal material used in the metal-clad laminate is generally roughened to ensure adhesion to the resin material. For example, Patent Literature 1 discloses a surface treatment method for roughening a copper foil to provide good adhesion to a resin film. In addition, Patent Literature 2 discloses a method for adhering a metal material to a resin material using a surface treatment liquid containing a triazole silane compound.

Resin materials having low dielectric properties are generally used in metal-clad laminates for high-frequency applications, but they have poor adhesive properties, and to improve adhesiveness, various methods are known, such as introducing specific functional groups into the resin or combining it with an adhesive resin. For example, Patent Literature 3 discloses a technique for improving adhesive strength by mixing low-adhesion polytetrafluoroethylene (PTFE) particles with a high-adhesion epoxy resin.

### 3. PRIOR ART

### Patent Literature

[Patent Literature 1] Japanese Patent Application Publication No. 2007-46095
[Patent Literature 2] WO 2018/186476 A
[Patent Literature 3] Japanese Patent Application Publication No. 2018-141053

### 4. SUMMARY OF THE INVENTION

In recent years, as communication speeds have increased, electrical signals have become increasingly frequent, and there is a demand for printed wiring boards that can accommodate this (high-frequency printed wiring boards). Specifically, there is a demand for a printed wiring board in which a metal material capable of suppressing transmission loss and a resin material having low dielectric properties are laminated. However, if the surface roughness of a metal material is high, conductor loss tends to increase due to the skin effect, and it is therefore undesirable to roughen the surface of a metal material to form deep irregularities, as disclosed in Patent Literature 1. Further, it is unclear whether the triazole silane compound described in Patent Literature 2 is effective in adhering metal materials and low dielectric resins.

Furthermore, in the high frequency region, materials with poor dielectric properties (high relative dielectric constant and dielectric loss tangent) exhibit significant dielectric loss, and therefore there is a need for a technology that can bond low dielectric resins and metal materials without relying on the method shown in Patent Literature 3.

In view of the above circumstances, one object of the present invention in one embodiment is to provide an adhesive for resin material having low dielectric properties that has excellent adhesion between metal materials (particularly metal materials with low surface roughness) and low dielectric resin materials. Further, one object of the present invention in one embodiment is to provide a laminate comprising a metal material layer, an adhesive layer formed from such an adhesive, and a low dielectric resin material layer.

The present invention relates to the following aspects.
[1] An adhesive for adhering a metal material and a low dielectric resin material, the adhesive comprising an organic amine compound (A) as a main component, wherein the organic amine compound (A) comprises at least one selected from a compound (B) having an amino group directly bonded to a nitrogen-containing aromatic ring and a compound (C) having a polyallylamine skeleton.
[2] The adhesive according to [1], wherein a mass proportion of the organic amine compound (A) in a nonvolatile content of the adhesive is 20% by mass to 100% by mass.
[3] A laminate comprising, in this order: a metal material layer; an adhesive layer formed from the adhesive according to [1] or [2]; and a low dielectric resin material layer.
[4] The laminate according to [3], wherein for surfaces of the metal material layer, a ten-point mean roughness (Rzjis) of at least a surface that is adhered to the low-dielectric resin material layer is 2.5 µm or less.
[5] The laminate according to [3] or [4], wherein a dielectric loss tangent of a low dielectric resin material constituting the low dielectric resin material layer is 0.0001 to 0.01 at a temperature of 23 °C and 10 GHz.
[6] A printed wiring board obtained by processing the metal material layer of the laminate according to any one of [3] to [5] into a wiring circuit.
[7] The printed wiring board according to [6], which is used for signals having a frequency of 25 GHz or more.
[8] An electronic device comprising the printed wiring board according to [6] or [7].
[9] A method for manufacturing a laminate, comprising adhering a metal material and a low dielectric resin material together with the adhesive according to [1] or [2] sandwiched therebetween.
[10] A method for manufacturing a laminate, comprising:
   a step of contacting the adhesive of [1] or [2] with a metal material to form a layer of the adhesive on the metal material;
   optionally, after the step of contacting, a step of drying the layer of the adhesive; and
   a step of contacting a low dielectric resin material with a surface of the layer of the adhesive and then applying heat and pressure.
[11] The method for manufacturing a laminate according to [10], wherein a deposition amount of the layer of the adhesive applied per unit area is 0.1 to 4000 mg/m².

According to one embodiment of the present invention, an adhesive having excellent adhesion between a metal material and a low dielectric resin material can be provided. In particular, it is possible to provide an adhesive that exhibits excellent adhesion between a metal material with low surface roughness and a low dielectric resin material with excellent dielectric properties. Further, since the adhesive exhibits excellent adhesive properties even at extremely low adhesion amounts, the thickness of the adhesive layer can be reduced as much as possible. For the above reason that the provision of an adhesive layer can reduce the deterioration of the dielectric properties of the laminate, the use of this adhesive can provide a metal-clad laminate with excellent adhesion between a metal material with low surface roughness and a low-dielectric resin material with excellent dielectric properties. The metal-clad laminate can be suitably used for printed wiring boards, particularly high-frequency printed wiring boards.

### 5. DETAILED DESCRIPTION OF THE INVENTION

### <1. Adhesives for low dielectric resin materials>

An adhesive for resin material having low dielectric properties according to one embodiment of the present invention is characterized in that it comprises an organic amine compound (A) as a main component, and that the organic amine compound (A) comprises at least one compound selected from the group consisting of a compound (B) having an amino group directly bonded to a nitrogen-containing aromatic ring and a compound (C) having a polyallylamine skeleton.

As used herein, the term "main component" refers to the component that accounts for the largest mass proportion among the components that contribute to adhesiveness. The mass proportion of the organic amine compound (A) in the nonvolatile content is preferably 20% by mass or more, more preferably 30% by mass or more, even more preferably 40% by mass or more, and even more preferably 50% by mass or more. While the upper limit is not particularly limited, it may be 100% by mass or less. Therefore, the mass proportion of the organic amine compound (A) in the nonvolatile content is preferably 20% by mass to 100% by mass, more preferably 30% by mass to 100% by mass, even more preferably 40% by mass to 100% by mass, and even more preferably 50% by mass to 100% by mass.

As used herein, the nonvolatile content refers to components having a boiling point of 170 °C or higher under an atmosphere of 760 mmHg.

In the adhesive of the present invention, the components other than the nonvolatile contents are a solvent and/or a dispersion medium. The solvent and/or dispersion medium is not particularly limited, and preferably has the effect of uniformly dissolving or dispersing the organic amine compound (A), and one or more types of solvents and/or dispersion media may be used in combination. A typical example is water.

As used herein, the organic amine compound (A) (hereinafter also referred to simply as "amine compound (A)") refers to an organic compound having an amino group and a salt thereof. The amino group referred to herein does not include those derived from nitrogen atoms in the ring structure of an aromatic ring. For example, -NH- in the ring structure of pyrrole is not considered as an amino group. The acid that forms a salt with the amino group may be either an inorganic acid or an organic acid. Examples of inorganic acids include hydrohalic acids, oxoacids, hydrocyanic acid, cyanic acid, and thiocyanic acid; examples of hydrohalic acids include hydrofluoric acid, hydrochloric acid, hydrobromic acid, and hydroiodic acid; examples of oxoacids include hypochlorous acid, chlorous acid, chloric acid, perchloric acid, nitric acid, nitrous acid, sulfuric acid, sulfurous acid, peroxomonosulfuric acid, peroxodisulfuric acid, phosphoric acid, phosphorous acid, hypophosphorous acid, carbonic acid, boric acid, silicic acid, chromic acid, dichromic acid, permanganic acid, molybdic acid, and tungstic acid. Further, examples of organic acids include carboxylic acids, percarboxylic acids, and sulfonic acids. Examples of carboxylic acid include an aliphatic carboxylic acid and an aromatic carboxylic acid. Examples of sulfonic acids include aliphatic sulfonic acids and aromatic sulfonic acids. Examples of aliphatic carboxylic acids include formic acid, acetic acid, propionic acid, butyric acid, valeric acid, lauric acid, myristic acid, palmitic acid, stearic acid, oleic acid, lactic acid, malic acid, citric acid, oxalic acid, malonic acid, succinic acid, glutaric acid, adipic acid, maleic acid, fumaric acid, malic acid, gluconic acid, monochloroacetic acid, dichloroacetic acid, trichloroacetic acid, and trifluoroacetic acid. Examples of aromatic carboxylic acids include benzoic acid, phthalic acid, isophthalic acid, terephthalic acid, salicylic acid, and gallic acid. Examples of percarboxylic acids include peracetic acid, and the like. Examples of aliphatic sulfonic acids include methanesulfonic acid, and the like. Examples of aromatic sulfonic acids include benzenesulfonic acid, and the like. The acids that form salts with amino groups may be used alone or in combination of two or more.

In the laminate according to one embodiment of the present invention, discoloration of the resin material was observed after the metal portion of the laminate was removed with an etching solution after thermocompression bonding. From this, it is presumed that the mechanism by which adhesiveness is obtained is that the amine compound (A) undergoes intermolecular and/or intramolecular elimination, addition, substitution, or oxidation reactions in the resin material that has softened and/or melted during thermocompression bonding, forming a network structure derived from the amine compound (A) in the resin material, thereby achieving high adhesiveness. Note that, the amine compound (A) is preferably a compound (C) having a structure in which hydrogen is present at the β-position of the amino group, and from the viewpoint of enamine formation, it is preferred that nitrogen be present at the γ-position of the amino group. In the present invention, the compound (B) having an amino group directly bonded to a nitrogen-containing aromatic ring and the compound (C) having a polyalkylamine skeleton may be used alone or in combination of two or more types thereof.

As used herein, the nitrogen-containing aromatic ring refers to an aromatic ring containing at least one nitrogen atom as an atom constituting a cyclic structure having aromaticity. The number of nitrogen atoms constituting the cyclic structure is not particularly limited. When the number of atoms constituting one cyclic structure is X and the number of nitrogen atoms is Y, the value of Y/X may be 0.07 or more, preferably 0.11 or more, more preferably 0.16 or more, even more preferably 0.33 or more, and even more preferably 0.60 or more. In addition, the value of Y/X is not particularly limited, but is preferably 0.8 or less. Therefore, the value of Y/X is, for example, preferably from 0.16 to 0.8, more preferably from 0.33 to 0.8, and even more preferably from 0.60 to 0.8. For example, a pyridine ring is a six-membered ring having one nitrogen atom, so X = 6 and Y = 1. Compounds having a nitrogen-containing aromatic ring include, but are not limited to, azoles and azines. Examples of the ring structure of the azole include, but are not limited to, a pyrrole ring, a diazole ring, a triazole ring, a tetrazole ring, an oxazole ring, an isoxazole ring, a thiazole ring, an isothiazole ring, an oxadiazole ring, and a thiadiazole ring. Examples of diazole rings include imidazole and pyrazole rings, and azine ring structures include, but are not limited to, pyridine, diazine, and triazine rings. Examples of diazine rings include a pyridazine ring, a pyrimidine ring, and a pyrazine ring. Further, the nitrogen-containing aromatic ring may have a polycyclic ring structure such as a bicyclic or tricyclic ring, and specific examples thereof include an indole ring, an isoindole ring, a benzotriazole ring, a purine ring, an azaindole ring, a benzoxazole ring, a benzothiazole ring, a benzothiadiazole ring, a quinoline ring, a naphthyridine ring, a carbazole ring, an acridine ring, a phenazine ring, a phenoxazine ring, a phenothiazine ring, and a phenanthroline ring, but are not limited to these. In addition, the above examples also include isomers in which the positions of heteroatoms (N, O, S) are different (for example, 1,2,3-triazole ring and 1,2,4-triazole ring). In addition, the azine may be in the form of a salt, and specific examples thereof include pyridinium salts, diazinium salts, and triazinium salts. The acid that forms a salt with the azine may be either an inorganic acid or an organic acid. Specifically, the acids that form salts with the amino group are the same as those described above. The acids that form salts with the azine may be used alone or in combination of two or more. In addition, the azole may be in the form of a salt and specific examples thereof include an alkali metal salt, an alkaline earth metal salt, or an onium salt. Examples of alkali metal salts include lithium salts, sodium salts, potassium salts, rubidium salts, cesium salts, and the like. Examples of alkaline earth metal salts include magnesium salts, calcium salts, strontium salts, barium salts, and the like. Examples of onium salts include ammonium salts and phosphonium salts, and the like. Examples of bases that form salts with azoles include alkali metal hydroxides, alkaline earth metal hydroxides, and ammonia. Examples of the alkali metal hydroxide include lithium hydroxide, sodium hydroxide, potassium hydroxide, rubidium hydroxide, and cesium hydroxide, and the like. Examples of the hydroxides of alkaline earth metals include magnesium hydroxide, calcium hydroxide, strontium hydroxide, and barium hydroxide, and the like.

In the present invention, the amino group in the compound (B) having an amino group directly bonded to a nitrogen-containing aromatic ring (hereinafter also simply referred to as "compound (B)") is preferably primary to tertiary, more preferably primary or secondary. In addition, the amino group may be in the form of a salt, but is preferably not be in the form of a salt. The number of amino groups bonded to one nitrogen-containing aromatic ring is not limited, but it is preferable that two or more amino groups be bonded to one nitrogen-containing aromatic ring as long as they have the same ring structure. The element constituting the nitrogen-containing aromatic ring and directly bonding to the amino group is preferably carbon or nitrogen. Examples of compound (B) include, but are not limited to, aminoazoles and aminoazines. Examples of aminoazoles include, but are not limited to, aminoazoles having a primary amino group, such as aminopyrrole, diaminopyrrole, aminodiazole, diaminodiazole, aminotriazole, diaminotriazole, triaminotriazole, aminotetrazole, diaminotetrazole, aminooxazole, diaminooxazole, aminoisoxazole, diaminoisoxazole, aminothiazole, diaminothiazole, aminoisothiazole, diaminoisothiazole, aminooxadiazole, diaminooxadiazole, aminothiadiazole, and diaminothiadiazole; aminoazoles having a secondary amino group, such as N-methylaminopyrrole, N,N'-dimethyldiaminopyrrole, N-methylaminodiazole, N,N'-dimethyldiaminodiazole, N-methylaminotriazole, N,N'-dimethyldiaminotriazole, N,N',N"-trimethyltriaminotriazole, N-methylaminotetrazole, N,N'-dimethyldiaminotetrazole, N-methylaminooxazole, N,N'-dimethyldiaminooxazole, N-methylaminoisoxazole, N,N'-dimethyldiaminoisoxazole, N-methylaminothiazole, N,N'-dimethyldiaminothiazole, N-methylaminoisothiazole, N,N'-dimethyldiaminoisothiazole, N-methylaminooxadiazole, N,N'-dimethyldiaminooxadiazole, N-methylaminothiadiazole, and N,N'-dimethyldiaminothiadiazole; and aminoazoles having a tertiary amino group, such as N,N-dimethylaminopyrrole, N,N,N',N'-tetramethyldiaminopyrrole, N,N-dimethylaminodiazole, N,N,N',N'-tetramethyldiaminodiazole, N,N-dimethylaminotriazole, N,N,N',N'-tetramethyldiaminotriazole, N,N,N',N',N", N"-hexamethyltriaminotriazole, N,N-dimethylaminotetrazole, N,N,N',N'-tetramethyldiaminotetrazole, N,N-dimethylaminooxazole, N,N,N',N'-tetramethyl diaminooxazole, N,N-dimethylaminoisoxazole, N,N,N',N'-tetramethyldiaminoisoxazole, N,N-dimethylaminothiazole, N,N,N',N'-tetramethyldiaminothiazole, N,N-dimethylaminoisothiazole, N,N,N',N'-tetramethyldiaminoisothiazole, N,N-dimethylaminooxadiazole, N,N,N',N'-tetramethyldiaminooxadiazole, N,N-dimethylaminothiadiazole, or N,N,N',N'-tetramethyldiaminothiadiazole. Examples of aminoazines include, but are not limited to, aminoazines having a primary amino group, such as aminopyridine, diaminopyridine, triaminopyridine, aminodiazine, diaminodiazine, triaminodiazine, aminotriazine, diaminotriazine, and triaminotriazine; aminoazines having a secondary amino group, such as N-methylaminopyridine, N,N'-dimethyldiaminopyridine, tri-N-methylaminopyridine, N-methylaminodiazine, N,N'-dimethyldiaminodiazine, N,N',N"-trimethyltriaminodiazine, N-methylaminotriazine, N,N'-dimethyldiaminotriazine, and N,N',N"-trimethyltriaminotriazine; and aminoazines having a tertiary amino group, such as N,N-dimethylaminopyridine, N,N,N',N'-tetramethyldiaminopyridine, N,N,N',N',N",N"-hexamethyltriaminopyridine, N,N-dimethylaminodiazine, N,N,N',N'-tetramethyldiaminodiazine, N,N,N',N',N",N"-hexamethyltriaminodiazine, N,N-dimethylaminotriazine, N,N,N',N'-tetramethyldiaminotriazine, and N,N,N',N',N",N"-hexamethyltriaminotriazine. As the compound (B), one type may be used alone, and two or more types may be used in combination, and a compound in which the amino group is in the form of a salt and a compound in which the amino group is not in the form of a salt may be used in combination. The above examples also include isomers in which the heteroatoms (N, O, S) are located at different positions (for example, 1,2,3-triazole ring and 1,2,4-triazole ring) and isomers in which the amino groups are located at different positions (for example, 2,6-diaminopyridine and 3,4-diaminopyridine).

The amino group on the nitrogen-containing aromatic ring may be appropriately chemically modified. For example, the hydrogen atom of the amino group may be substituted with an alkyl group, a hydroxyalkyl group, a carboxyalkyl group, a phenyl group, or the like. Further examples include hydroxyalkylation (e.g., hydroxyethylation) by reaction with an epoxy compound. In addition, it is preferred that the compound (B) itself not contain Si, and that the amino group on the nitrogen-containing aromatic ring not be chemically modified.

The nitrogen atoms constituting the nitrogen-containing aromatic ring may be appropriately chemically modified. For example, the nitrogen atom may be modified with an alkyl group, a hydroxyalkyl group, a carboxyalkyl group, a phenyl group, or the like. In addition, it is preferable that the nitrogen atom constituting the nitrogen-containing aromatic ring not be chemically modified with a functional group containing Si, and not be chemically modified with an N-C bond formation.

As used herein, the compound (C) having a polyalkylamine skeleton (hereinafter also simply referred to as the compound (C)) refers to a compound having two or more repeating units having an alkylamine structure. The number average molecular weight of the compound (C) is preferably 150 or more, more preferably 185 or more, and particularly preferably 250 or more. In addition, the number average molecular weight is preferably 200,000 or less, more preferably 120,000 or less, even more preferably 100,000 or less, and particularly preferably 80,000 or less. Therefore, the number average molecular weight of the compound (C) is, for example, preferably 150 to 200,000, more preferably 185 to 120,000, even more preferably 250 to 100,000, and particularly preferably 250 to 80,000. The repeating unit may be a single structure or may contain two or more different repeating unit structures. In addition, the repeating units constituting the compound (C) may be linear or branched. Specific examples of the compound (C) include, but are not limited to, ethyleneamines, polyallylamine, and polydiallylamine. The ethyleneamines as used herein are those having two or more ethylene groups (-CH₂-CH₂-) linking amino groups together, and specific examples thereof include polyethyleneimine, aminoethylpiperazine, tris(2-aminoethyl)amine, N,N'-bis-(2-aminoethyl)piperazine, diethylenetriamine, triethylenetetramine, tetraethylenepentamine, pentaethylenehexamine, and hexaethyleneheptamine, and the like. The compound (C) is preferably polyethyleneimine, and branched polyethyleneimine is more preferred than linear polyethyleneimine. In addition, the number of ethylene groups linking the amino groups in the ethyleneamines is preferably 2 or more, more preferably 3 or more, even more preferably 4 or more, even more preferably 5 or more, and particularly preferably 6 or more.

When the mass of nitrogen in the repeating unit of the compound (C) is p and the mass of the repeating unit is q, the value of p/q is preferably 0.08 or more, more preferably 0.10 or more, even more preferably 0.13 or more, particularly preferably 0.23 or more, and most preferably 0.30 or more. In addition, the value of p/q is preferably 0.4 or less, and more preferably 0.35 or less. Therefore, the value of p/q is, for example, preferably from 0.08 to 0.4, more preferably from 0.10 to 0.4, even more preferably from 0.13 to 0.4, particularly preferably from 0.23 to 0.4, and most preferably from 0.30 to 0.35.

The number average molecular weight of the compound (C) is measured by the GPC method. When the adhesive contains two or more types of compound (C) having different repeating units, the molecular weight is measured in a mixed state.

The compound (C) may or may not have a phenyl group in the repeating unit.

The amino group in the compound (C) may be appropriately chemically modified. For example, the hydrogen atom of the amino group may be substituted with an alkyl group, a hydroxyalkyl group, a carboxyalkyl group, a phenyl group, or the like. Further examples include hydroxyalkylation (example: hydroxyethylation) by reaction with an epoxy compound, and the like. Note that, it is preferable that the amino group not be chemically modified with a functional group containing Si, it is more preferable that the compound (C) itself not contain Si, and it is even more preferable that the amino group not be chemically modified.

The organic amine compound (A) used in the present invention preferably has an ignition residue when heated at 265 °C under atmospheric pressure for 1 hour, more preferably 10% or more of the residue, even more preferably 15% or more of the residue, particularly preferably 20% or more of the residue, and most preferably 25% or more of the residue.

The method for measuring the ignition residue in this embodiment is as follows:
(1) A measurement sample is diluted with a solvent or dispersion medium to prepare a solution or dispersion of 1% by mass of the measurement sample. The solvent or dispersion medium used is the same as that used for the adhesive. When a solvent or a dispersion medium is not used in the adhesive, water is used. Water is usually the preferred solvent or dispersion medium.
(2) The weight m of the fluororesin Petri dish is measured using an electronic balance capable of measuring in grams to four decimal places. In addition, before the measurement, the petri dish to be used is heated at 265 °C for 1 hour to confirm that there is no weight loss.
(3) The solution or dispersion diluted in (1) is dropped onto a petri dish, and the weight n of the dropped solution or dispersion is measured.
(4) The petri dish is placed in a stainless steel tray, the opening is covered with aluminum foil, several holes with a diameter of about 1 cm are made to allow volatile components to escape, and the petri dish is placed in a hot air circulating drying oven and heated at 265 °C for 1 hour.
(5) After (4), the petri dish is taken out and allowed to cool until the sample temperature reaches 30 °C, and after cooling, the weight M of the compound A and the petri dish after heating is measured.
(6) The ignition residue is calculated using the following formula (i):$Ignition residue \left(%\right) = \left\{\left(M-m\right) / \left(n\times 0.01\right)\right\} \times 100$ Formula (i)
(7) The above measurement is carried out four times, and the arithmetic mean value is used as the evaluation value.

Further, in the adhesive, when the number of moles of active hydrogen of the amino group in the organic amine compound (A) is x and the number of moles of functional groups that can easily undergo an addition reaction with the active hydrogen of the amino group in a 1:1 ratio is y, the ratio y/x is preferably 1.50 or less, more preferably 1.20 or less, even more preferably 1.00 or less, particularly preferably 0.80 or less, and most preferably 0.67 or less. The lower limit is not particularly limited, but it is usually preferable that it be closer to 0. The functional group capable of undergoing a 1:1 addition reaction with the active hydrogen of the amino group is not particularly limited as long as it is a functional group that undergoes nucleophilic attack by the unshared electron pair of the amino group under relatively mild conditions (for example, 25 °C to 220 °C, 1 kgf/cm²) to form a covalent bond, and examples thereof include an isocyanate group, a blocked isocyanate group, and an epoxy group, and the like. The blocking agent for the blocked isocyanate is not particularly limited, and examples thereof include acetoxime, phenol, ε-caprolactam, active methylene compounds, triazole, and pyrazole, and the like.

### <2. Laminate>

A laminate according to one embodiment of the present invention comprises, in this order, a metal material layer, an adhesive layer formed from the above-described adhesive for resin material having low dielectric properties, and a low dielectric resin material layer. Typically, the laminate is provided as a metal-clad laminate comprising, in this order, a copper-based material sheet or an aluminum-based material sheet, an adhesive layer formed from the above-mentioned adhesive for low dielectric resin material, and a low dielectric resin sheet.

In a metal-clad laminate, a copper-based or aluminum-based material sheet (hereinafter also referred to as a "metal material sheet") may be laminated on one or both sides of a resin sheet, or on the entire surface or part of the surface of the resin sheet.

The adhesive layer (hereinafter referred to as "adhesive layer") formed from an adhesive for resin material having low dielectric properties is usually formed on the entire adhering surface of the metal material sheet with the resin sheet, but may also be formed on a part of the adhering surface of the metal material sheet with the resin sheet. Similarly, the adhesive layer may be formed on the entire adhering surface of the resin sheet with the metal material sheet, or may be formed on only a part of the adhering surface. In addition, when metal material sheets are laminated on both sides of a resin sheet, it is sufficient that at least one of the metal material sheets be laminated to the resin sheet via an adhesive layer according to one embodiment of the present invention, but it is preferable that both metal material sheets be laminated to the resin sheet via an adhesive layer according to one embodiment of the present invention. The two metal material sheets laminated on both sides of the resin sheet may be the same or different, and the two adhesive layers may also be the same or different. When the metal material sheet is laminated on one side of the resin sheet, another layer may be laminated on the side of the resin sheet opposite to the side on which the metal material sheet is laminated. Examples of other layers include, but are not limited to, a release film layer for protecting the resin sheet. In addition, the metal-clad laminate may also be one in which another layer is further laminated on the surface of the metal material sheet opposite to the surface on which the resin sheet is laminated. This another layer may be a layer of an adhesive for resin material having low dielectric properties, that is, an adhesive layer formed from an adhesive containing an organic amine compound (A) as a main component.

### [2-1. Metal materials]

The metal material is not particularly limited, but may be a material containing copper, copper alloy, aluminum, or aluminum alloy as the main component (the total concentration of copper, copper alloy, aluminum, or aluminum alloy in the material is 50% by mass or more, preferably 60% by mass or more, more preferably 75% by mass or more, even more preferably 85% by mass or more, for example, 50 to 100% by mass), and a material primarily containing copper or copper alloy as the main component is preferred (the total concentration of copper and copper alloy in the material is 50% by mass or more, preferably 60% by mass or more, more preferably 75% by mass or more, even more preferably 85% by mass or more, for example, 50 to 100% by mass). Metal materials are typically provided in the form of sheets such as plates and foils, and the like. The sheets may be composed of a single layer or may be composed of two or more layers laminated together. The aluminum content in the aluminum alloy is not particularly limited, but is preferably 50% by mass or more, more preferably 60% by mass or more, even more preferably 75% by mass or more, and particularly preferably 85% by mass or more. Specific examples of aluminum alloys include known alloys such as those specified by JIS H4000: 2014 and JIS H4160: 1994, but are not limited to these. The copper content in the copper alloy is not particularly limited, but is preferably 50% by mass or more, more preferably 60% by mass or more, even more preferably 75% by mass or more, and particularly preferably 85% by mass or more. Specific examples of copper alloys include copper-zinc alloys, copper-iron-phosphorus alloys, copper-tin alloys, copper-zirconium alloys, copper-nickel alloys, and copper-silver alloys, and the like as defined in JIS H3100: 2012 or the CDA (Copper Development Association) standard, but are not limited to these. The metal material may be one that has been subjected to a surface treatment that is generally applied to copper foil or copper alloy foil of a metal-clad laminate used in a printed wiring board. Examples of surface treatments include plating treatments such as single metal plating treatment or alloy plating treatment, and chromate treatment, and the like. The plating treatment may be any known plating treatment, and examples thereof include single metal plating treatment or alloy plating treatment containing one or more elements selected from the group consisting of nickel, zinc, tin, cobalt, molybdenum, copper, tungsten, phosphorus, arsenic, chromium, vanadium, titanium, aluminum, gold, silver, platinum group elements, iron, and tantalum. The plating process may be a single layer plating or a multilayer plating of two or more layers. Further, the metal material may be surface-treated with a coupling agent such as a silane coupling agent, but according to the present invention, excellent adhesion between the metal material and the low dielectric resin material can usually be obtained without surface-treating the metal material with a coupling agent. In addition, such surface treatment can be carried out according to a known method.

The form of the metal material is not particularly limited, and examples thereof include a plate, foil, strip, and lump, and the like, and examples of the plate that can be used include a rolled plate, and examples of the foil that can be used include an electrolytic metal foil. Further, the surfaces of these materials may be subjected to the above-mentioned surface treatment. In addition, as the foil, a metal foil with a carrier and a foil whose surface has been subjected to the above-mentioned surface treatment can be used. In this case, the metal foil that is not the carrier of the metal foil with a carrier can be used as the metal material according to one embodiment of the present invention. The carrier of the metal foil with a carrier is not particularly limited, and any of those commonly used as a carrier, such as metal foils such as electrolytic copper foil and electrolytic aluminum foil, and resin films, can be used. The thickness of the carrier is not particularly limited and can be selected appropriately. As the metal foil with a carrier, an electrolytic copper foil with a carrier and an electrolytic copper alloy foil with a carrier are generally used, but the present invention is not limited thereto. In the present invention, plates, foils, strips and ingots of copper, copper alloys, aluminum or aluminum alloys are preferred. In addition, laminates having metal materials such as plated materials and clad materials on the surface thereof, and those metal materials whose surfaces have been subjected to the above-mentioned surface treatments, can also be suitably used. In this case, the metal material contained in the laminate becomes the metal material of the laminate according to one embodiment of the present invention. In the present invention, plated or clad materials of copper, copper alloy, aluminum or aluminum alloy are preferred. Further, a low dielectric resin material can be laminated onto the metal material contained in the metal-clad laminate produced by an existing method or in this embodiment via the adhesive for resin material having low dielectric properties, and the laminate obtained in this manner is also a laminate according to an embodiment of the present invention.

It is generally preferred that the metal material have a smooth surface. In particular, when the metal material is provided in the form of a sheet such as a plate or foil or the like, it is preferred that at least the adhering surface to the low dielectric resin material layer be smooth, and it is more preferred that both surfaces be smooth. Specifically, for surfaces of the metal material, the ten-point mean roughness (Rzjis) of at least the surface that is adhered to the low dielectric resin material layer, preferably both surfaces, is preferably 10 µm or less, more preferably 5 µm or less, even more preferably 2.5 µm or less, particularly preferably 1.8 µm or less, and most preferably 1.0 µm or less. In addition, it is generally preferred that the surface of the metal material not be subjected to a roughening treatment. The lower limit of the ten-point mean roughness (Rzjis) of the surface of the metal material is not particularly limited, and generally, the closer to 0 µm the better. The ten-point mean roughness of the surface of the metal material is illustratively in the range of 0.0001 µm to 10 µm, preferably in the range of 0.001 µm to 5 µm, and more preferably in the range of 0.01 µm to 2.5 µm. In addition, the ten-point mean roughness (Rzjis) can be measured using a laser microscope (VK-X1000 manufactured by Keyence Corporation) in accordance with JIS B0601: 2001.

When the metal material is in the form of a sheet, the thickness is not particularly limited and can be appropriately selected depending on the application, but is usually preferably 0.5 µm to 1000 µm, more preferably 1 µm to 100 µm. In addition, the adhesion area of the metal material to the low dielectric resin material is not particularly limited and can be appropriately selected depending on the application.

### [2-2. Low dielectric resin materials]

The low dielectric resin material may be any material containing a low dielectric resin, and may be composed of resin only, or may contain components other than resin. When the low dielectric resin material contains components other than resin, the resin may be the main component (resin concentration is 50% by mass or more), or may not be the main component. Examples of components other than resin include inorganic fibers, specifically carbon fibers, glass fibers, and the like. Examples of low dielectric resin materials containing components other than resin include materials in which inorganic fibers (which may be in the form of woven or nonwoven fabric) are impregnated with resin or a resin composition, typically prepreg. The low dielectric resin material is typically provided in the form of a sheet such as a film or prepreg. The sheet may be composed of a single layer or may be composed of two or more layers laminated together. Further, the sheet may be either soft (flexible) or hard (rigid). The resin contained in the low dielectric resin material may be one type of resin or a mixture of two or more types of resins. Further, the low dielectric resin material may contain inorganic particles (filler) and various other additives, if necessary. In addition, the components other than the resin that can be contained in the low dielectric resin material are not particularly limited, and other components than those mentioned above can also be used.

The low dielectric resin material as used herein refers to a resin material having a relative dielectric constant of 4.0 or less and a dielectric loss tangent of 0.01 or less at a temperature of 23 °C and 10 GHz. The low dielectric resin material can be appropriately selected depending on the application, but thermoplastic resins are preferably used. In addition, at a temperature of 23 °C and 10 GHz, resins having a relative dielectric constant of 4.0 or less are preferred, resins having a relative dielectric constant of 3.4 or less are more preferred, and resins having a relative dielectric constant of 3.1 or less are particularly preferred. Typically, a resin having a relative dielectric constant of greater than 1.0 to 4.0, more typically 1.1 to 4.0 at a temperature of 23 °C and 10 GHz can be used. The dielectric constant of a resin can be measured using the cavity resonator method in accordance with IEC 62810. Further, the dielectric loss tangent at a temperature of 23 °C and 10 GHz is preferably 0.01 or less, more preferably 0.008 or less, even more preferably 0.006 or less, particularly preferably 0.004 or less, and most preferably 0.003 or less. Typically, a resin having a dielectric loss tangent at a temperature of 23 °C and 10 GHz of 0.0001 to 0.01, more typically 0.0003 to 0.01, and even more typically 0.0005 to 0.01 can be used. The dielectric tangent of a resin can be measured by the cavity resonator method in accordance with IEC 62810.

Examples of low dielectric resin materials include fluororesin, polyphenylene ether resin (PPE), maleimide resin, hydrocarbon resin, modified polyimide resin, aromatic polyether resin, and polyphenylene sulfide resin (PPS), and the like. Examples of fluororesins include polytetrafluoroethylene (PTFE), perfluoroalkoxyalkane (PFA), perfluoroethylenepropene copolymer (FEP), ethylene-tetrafluoroethylene copolymer (ETFE), ethylene-chlorotrifluoroethylene copolymer (ECTFE), polyvinylidene fluoride (PVDF), polyvinyl fluoride (PVF), polychlorotrifluoroethylene (PCTFE), and ethylene-chlorotrifluoroethylene copolymer (ECTFE), and the like. Examples of hydrocarbon resins include butadiene hydrocarbons, cycloolefin polymers (COP), and cycloolefin copolymers (COC), and the like. Examples of butadiene hydrocarbons include liquid polybutadiene and styrene butadiene styrene (SBS), and the like. Examples of aromatic polyether resins include liquid crystal polymers and polyether ether ketone (PEEK), and the like. In the present invention, among the low dielectric resin materials, PEEK and fluororesin are preferred, fluororesin is more preferred, and PTFE is particularly preferred.

As the low dielectric resin material, resin films and prepregs commercially available as low dielectric resin materials for printed wiring boards can also be used.

When the low dielectric resin material is in the form of a sheet, the thickness is not particularly limited and can be appropriately selected depending on the application, but is usually preferably 10 µm to 1000 µm, more preferably 20 µm to 500 µm.

### [2-3. Manufacturing method of laminate]

A laminate according to one embodiment of the present invention, typically a metal-clad laminate, can be manufactured by adhering a metal material and a low dielectric resin material together with the above-mentioned adhesive for resin material having low dielectric properties. The method for sandwiching the adhesive between the metal material and the low dielectric resin material is not particularly limited, but preferably, the low dielectric resin material can be manufactured by forming a layer of adhesive for the low dielectric resin material (layer of adhesive) on the surface of the metal material, and then adhering the low dielectric resin material onto the layer of the adhesive. When forming a layer of adhesive on the surface of a low dielectric resin material, in order to improve the applicability of the adhesive to the low dielectric resin material, an appropriate leveling agent may be added to the adhesive or an activation treatment may be performed on the surface of the low dielectric resin material in advance. Specific examples of activation treatments include corona treatment, flame treatment, ozone treatment, ultraviolet treatment, radiation treatment, plasma treatment, and primer treatment, and the like. The adhesive for the low dielectric resin material may be provided in a liquid form, or may be provided in a sheet form (for example, a sheet-shaped hot melt adhesive). When the adhesive for resin material having low dielectric properties is in liquid form, an example of a method is to form a layer of adhesive on the surface of a metal material, as described below, and then adhere the low dielectric resin material onto the layer of the adhesive. When the adhesive for resin material having low dielectric properties is in the form of a sheet, the adhesive may be sandwiched between the metal material and the low dielectric resin material to adhere them together. A preferred method for manufacturing a laminate according to one embodiment of the present invention will be described below as an example, but the method for producing a laminate is not limited to the following method.

First, a layer of adhesive is formed on a metal material, typically a copper-based material sheet or an aluminum-based material sheet such as copper foil, copper plate, copper alloy foil or copper alloy plate (which may have been subjected to the above-mentioned surface treatment), or when a laminate having a metal material on its surface is used, a layer of adhesive is formed on the metal material (which may have been subjected to the above-mentioned surface treatment).

The layer of the adhesive can be formed, for example, by dissolving or dispersing an adhesive for resin material having low dielectric properties containing an organic amine compound (A) in a solvent or dispersion medium to prepare a liquid adhesive for forming an adhesive layer, applying this to the surface of the metal material, and then drying it.

The content of each compound in the adhesive is not particularly limited and can be selected appropriately.

The solvent or dispersion medium used in the adhesive is not particularly limited and can be appropriately selected from commonly used solvents, and organic solvents can also be used, but water is usually preferred. The solvent or dispersion medium may be used in combination of two or more types.

The adhesive may contain various commonly used additives (For example, inorganic compounds, organic compounds such as resins (for example, acrylic resins, epoxy resins, urethane resins, ether resins, amide resins, alkylene vinyl acetate copolymers, polyvinyl alcohols, polyalkylene glycols, styrene-maleic anhydride copolymers, oxidized modified polyalkylene resins, thickening polysaccharides, and cellulose nanofibers, which are generally used as binders), surfactants, defoamers, leveling agents, antibacterial agents, antifungal agents, dyes, pigments, fragrances, antiblocking agents, release agents, rust inhibitors, and the like) as needed, or may not contain any additives.

The application of the adhesive is not particularly limited and can be carried out by a known method, such as a bar coating method, a spray method, a spin coating method, a roll coating method, a curtain coating method, an electrostatic powder coating method, a fluidized bed dip coating method, or a dipping method.

The drying conditions after application of the adhesive are not particularly limited and can be selected as appropriate, but it is usually preferable to heat and dry the metal material so that the peak metal temperature (PMT) reaches 60 °C to 300 °C. The drying temperature is not particularly limited as long as it can dry the adhesive and form a layer of the adhesive, but it is more preferable that the peak metal temperature (PMT) of the metal material is in the range of 60 °C to 250 °C, and particularly preferably in the range of 60 °C to 180 °C. The drying time is not particularly limited as long as it is possible to dry the adhesive and form a layer of the adhesive, but may be, for example, 0.5 minutes or more, 1 minute or more, 5 minutes or more, 10 minutes or more, 120 minutes or less, 60 minutes or less, or 20 minutes or less.

Note that before forming the layer of the adhesive, the metal material may be subjected to a cleaning treatment such as solvent degreasing, acid degreasing, alkali degreasing, solvent washing, acid washing, alkali washing, or water washing, and drying after the cleaning treatment, if necessary. Such cleaning treatment and drying can be carried out according to known methods. The deposition amount of adhesion per unit area of the layer of the adhesive is not particularly limited, but from the viewpoint of adhesiveness and making the most of the properties of the low dielectric resin material, it is preferably 0.1 to 4000 mg/m², more preferably 0.3 to 2000 mg/m², even more preferably 0.3 to 1500 mg/m², even more preferably 0.3 to 1000 mg/m², even more preferably 0.3 to 700 mg/m², even more preferably 0.3 to 600 mg/m², even more preferably 0.3 to 500 mg/m², even more preferably 0.3 to 250 mg/m², and particularly preferably 0.3 to 125 mg/m². Note that the deposition amount of the layer of the adhesive is the deposition amount of adhesive attached per side (one layer). The deposition amount of the layer of the adhesive is calculated by burning all organic matter in the adhesive using a total organic carbon (TOC) meter and quantifying the amount of carbon. The specific calculation method is shown below. The carbon content ratio d (%) in the solid content concentration of the adhesive is calculated by applying the solid content concentration a (% by mass) of a measurement sample (for example, diluted 5000 times) obtained by diluting the adhesive (for example, solid content concentration of 3% by mass, 10% by mass, or 30% by mass), the carbon content per volume b (mg/L) of the measurement sample measured with a TOC meter, and the density c (g/L) of the measurement sample to the following equation 1.$d = \left[b / \left\{c\times \left(a / 100\right)\times 1000\right\}\right] \times 100$ Formula 1 ... Formula 1

Next, the carbon amount in the layer of the adhesive of the measurement sample on which the layer of the adhesive has been formed is measured using a TOC meter, and the carbon amount measurement value e (mg) and the area f (m²) on which the layer of the adhesive has been formed on the measurement sample are applied to the following equation 2 to calculate the coating amount g (mg/m²).$g = \left\{e / (\left(d / 100\right)\right\} / f$ Formula 2

Further, when the coating amount calculated by the above method is 2000 mg/m² or more, the deposition amount is calculated by the weight method using the following formula 3. The weight of the copper foil before treatment is h (mg), the weight of the copper foil after the layer of the adhesive is formed is i (mg), the measured area of the portion of the copper foil on which the layer of the adhesive is formed is j (m), and the deposition amount is k (mg/m²).$k = \left(i-h\right) / j$ Formula 3

The thickness of the layer of the adhesive is not particularly limited and can be selected as appropriate so that the amount of adhesion falls within the above range, but is preferably 0.1 nm or more, more preferably 0.3 nm or more, even more preferably 1 nm or more, preferably 4000 nm or less, more preferably 2000 nm or less, even more preferably 1500 nm or less, even more preferably 1000 nm or less, particularly preferably 700 nm or less, and most preferably 500 nm or less.

Next, a low dielectric resin material is brought into contact with the surface of the layer of the adhesive thus formed on the surface of the metal material, and, for example, a low dielectric resin material, typically a resin sheet such as a resin film or prepreg, is superimposed on the layer of the adhesive, and the layers are heated and pressurized to adhere them together, thereby manufacturing the laminate according to this embodiment. The layer of the adhesive is altered by the evaporation of volatile components and polymerization when heated and pressurized, and therefore the layer of the adhesive after heating and pressurization is called the adhesive layer. When manufacturing a laminate in which a metal material is laminated on both sides of a low dielectric resin material, the metal material may be adhered to both sides of the low dielectric resin material, such as a resin film or prepreg, simultaneously via the layer of the adhesive, or may be adhered to each side in turn.

The method for adhering a metal material having the layer of the adhesive formed on its surface to a resin film or prepreg is not particularly limited, and can be carried out using a known heating and pressing apparatus. The pressing conditions (pressing pressure) are not particularly limited and can be appropriately selected depending on the material and resin type used, and may be 1 to 1000 kgf/cm², preferably 5 to 100 kgf/cm². The heating conditions are not particularly limited and can be appropriately selected depending on the material and type of resin used, and may be 80 °C to 600 °C, preferably 150 °C to 450 °C, but a temperature above the temperature at which the resin becomes fluid when heated is desirable. After the resin has temporarily become fluid, it may become non-fluid by thermal curing or the like. In addition, from the viewpoint of polymerizing and/or condensing the amine compound during adhesion, the temperature is preferably 150 °C or higher, more preferably 180 °C or higher, even more preferably 200 °C or higher, particularly preferably 230 °C or higher, and most preferably 260 °C or higher. Further, from the viewpoint of thermal decomposition of the resin substrate and adhesive, the temperature is preferably 800 °C or less, more preferably 700 °C or less, and particularly preferably 600 °C or less. The adhesion time is not particularly limited, but may be from 0.1 to 1440 minutes, preferably from 0.5 to 600 minutes.

During the heating and pressing, the pressure may be reduced from normal pressure, or the heating and pressing may be carried out in a state where air is blocked, or the heating and pressing may be carried out in an inert gas (for example, nitrogen gas, helium gas, or argon gas) atmosphere.

The peel strength (peel strength) between the metal material layer and the resin material layer of a metal-clad laminate can be measured in accordance with JIS C5012: 1993. The peel strength is preferably from 2.5 N/cm to the breaking strength of the resin material layer, more preferably from 5.0 N/cm to the breaking strength of the resin material layer, and most preferably from 7.5 N/cm to the breaking strength of the resin material layer. The breaking strength of the resin material layer is generally 8.0 N/cm or more. In other words, the peel strength of the metal-clad laminate is preferably higher than the breaking strength of the resin material layer.

A printed wiring board can be manufactured by processing the metal material layer of the laminate according to this embodiment into a wiring circuit. The laminate according to this embodiment can be suitably used for printed wiring boards that use high-frequency signals, for example, signals with frequencies of 25 GHz or higher. The printed wiring boards can be mounted on various electronic devices.

### 6. EXAMPLES

Hereinafter, the present invention will be described in more detail below with reference to Examples and Comparative Examples, but the present invention is not limited to the following Examples.

The raw materials used in the examples and comparative examples are shown below. Unless otherwise specified, compounds manufactured by Fujifilm Wako Pure Chemical Industries, Ltd. were used.

### [Raw materials]

[Compound (B) having an amino group directly bonded to a nitrogen-containing aromatic ring]
(B-1) 3,5-diamino-1,2,4-triazole (Tokyo Chemical Industry Co., Ltd.)
(B-2) 3-amino-1,2,4-triazole
(B-3) 5-aminotetrazole
(B-4) 5-aminotetrazole Na salt (5-aminotetrazole neutralized with sodium hydroxide)
(B-5) 2,6-diaminopyridine
(B-6) 2,4,6-triaminopyrimidine

[Compound (C) having a polyalkylamine skeleton]
(C-1) Triethylenetetramine
(C-2) Tetraethylenepentamine
(C-3) Pentaethylenehexamine
(C-4) PAA (Registered Trademark)-1 (Polyallylamine) (Nittobo Medical Co., Ltd.)
(C-5) PAS (Registered Trademark)-21 (Polydiallylamine) (Nittobo Medical Co., Ltd.)
(C-6) Epomin (Registered Trademark) SP-003 (Poly Ethyleneimine (number average molecular weight 300) (manufactured by Nippon Shokubai Co., Ltd.)
(C-7) Epomin (Registered trademark) SP-006 (polyethyleneimine (number average molecular weight 600) (manufactured by Nippon Shokubai Co., Ltd.)
(C-8) Epomin (Registered trademark) P-1000 (polyethyleneimine (number average molecular weight 70,000) (manufactured by Nippon Shokubai Co., Ltd.)
(C-9) Lupasol (Registered trademark) FG (polyethyleneimine (weight average molecular weight 800) (manufactured by BASF SE)

### [Metal material]

(D-1) Electrodeposited copper foil (thickness 18 µm, Rzjis 0.15 µm, Ra 0.04 µm) having a surface with a heat-resistant plating layer and an electrolytic chromate layer, in this order, from the outside to the inside.
(D-2) Electrodeposited copper foil (thickness 18 µm, Rzjis 0.09 µm, Ra 0.02 µm)
(D-3) Pure aluminum plate (thickness 0.8 mm, Rzjis 0.14 µm, Ra 0.01 µm)
(D-4) Electrodeposited copper foil (thickness 18 µm, Rzjis 0.16 µm, Ra 0.04 µm) having a silane coupling agent layer, a heat-resistant plating layer, and an electrolytic chromate layer, in this order, from the outside to the inside.

### [Low dielectric resin materials]

(E-1) PTFE Prepreg (Rogers Corporation, product name "RO3003 Bondply", thickness 0.1 mm)
(Catalog values: relative permittivity 3.0 ± 0.04, dielectric loss tangent 0.0010 at 23 °C and 10 GHz) (Measured values: Relative permittivity 2.44, dielectric loss tangent 0.00063 at 23 °C and 10 GHz)
(E-2) PEEK-based Prepreg (thickness 0.05 mm) (Catalog values: Relative permittivity 2.8, dielectric loss tangent 0.0033 at 23 °C and 10 GHz) (Measured values: Relative permittivity 2.88, dielectric loss tangent 0.00337 at 23 °C and 10 GHz)

### [Compound (F)]

(F-1) Imidazole
(F-2) 1,2,4-triazole
(F-3) Tetrazole
(F-4) Aniline oxalate (aniline neutralized with oxalic acid)
(F-5) Bismarck Brown

### [Water-based resins (G)]

(G-1) MODEPIX (registered trademark) 302 (Arakawa Chemical Industries, Ltd.) (epoxy resin)
(G-2) GOHSENEX (Registered trademark) LW-100 (Nippon Synthetic Chemical Industry Co., Ltd.) (sulfo-modified PVOH)
(G-3) ARROWBASE (Registered trademark) YA-6010 (Unitika Ltd.) (modified polypropylene)
(G-4) AQUALIC (Registered trademark) HL415 (Nippon Shokubai Co., Ltd.) (polyacrylic acid)
(G-5) VONCOAT (Registered trademark) CF-6140 (DIC Corporation) (acrylic resin)
(G-6) ELITEL (Registered trademark) KT-507 (Unitika Ltd.) (ester resin)

### [Epoxy Adhesives (H)]

(H-1) ThreeBond (Registered trademark) 2086M Main Agent (epoxy resin) / curing agent (polythiol)
(H-2) jER (Registered trademark) 828EL (Mitsubishi Chemical Corporation) (epoxy compound (bisphenol A epoxy resin)) / pentaethylenehexamine (used as amine curing agent)
(H-3) jER (Registered Trademark) 828EL (Mitsubishi Chemical Corporation) (Epoxy Compound (Bisphenol A Epoxy Resin)) / Epomin SP-006 (Used as Amine Curing Agent)
(H-4) Denacol (Registered Trademark) EX313 (Mitsubishi Chemical Corporation) (Epoxy
Compound (Glycerol Polyglycidyl Ether)) / Pentaethylenehexamine (Used as Amine Curing Agent)

### [High dielectric resin materials (I)]

(I-1) Epoxy Resin Prepreg (Showa Denko Materials Co., Ltd., product name "GEA-679N")
(Measured values: relative permittivity 3.20, dielectric loss tangent 0.0225 at 23 °C and 10 GHz)

### [Materials other than resin]

(J-1) Glass fiber cloth
(J-2) SUS foil (AS ONE Corporation, thickness 0.1 mm)

The glass fiber cloth (J-1) was prepared by placing an epoxy resin prepreg (manufactured by Showa Denko Materials Co., Ltd., product name "GEA-679N") in chloroform heated to 60 °C, completely dissolving the epoxy resin, and then extracting only the glass fiber cloth. This was then immersed again in different chloroform heated to 60 °C to remove the remaining epoxy resin, and then dried at 80 °C for 1 minute in a circulating drying oven.

### <Manufacture of metal-clad laminate>

### [Formation of layer of adhesive for low dielectric resin material]

### [Example 1]

As the metal material, an electrolytic copper foil (thickness 18 µm, Rzjis 0.15 µm, Ra 0.04 µm) (D-1) having a surface provided with a heat-resistant plating layer and an electrolytic chromate layer in this order from the outside to the inside was prepared. The solid content concentration of the compound (B-1) in which an amino group is directly bonded to a nitrogen-containing aromatic ring was adjusted with ion-exchanged water so that the layer of the adhesive formed on the copper foil surface would have a deposition amount of 12 mg/m², and an aqueous solution of the adhesive was prepared. This was then applied (by bar coating) to the surface of the copper foil having the plating layer and the electrolytic chromate layer. The mass proportion of the compound (B-1) excluding water in the adhesive is shown in Table 1. Thereafter, the adhesive was dried at 100 °C for 1 minute in a hot air circulation drying oven to form a layer of the adhesive on the copper foil surface.

### [Adhering between a metal material having a layer of adhesive formed thereon and a low dielectric resin material]

A PTFE prepreg (manufactured by Rogers Corporation, product name "RO3003 Bondply", thickness 0.1 mm) (E-1) was placed on to the surface of the layer of the adhesive formed on the metal material, and the matte surface of an electrolytic copper foil having a thickness of 35 µm was placed as a ground layer on the backside of the adhered surface of the above (E-1), so as to laminate the metal material, the layer of the adhesive, (E-1), and the ground layer in this order. Note that the ground layer was provided because it was necessary for the adhesiveness evaluation described later. The sheets were then wrapped in aluminum foil and sealed off from the atmosphere to manufacture metal-clad laminates. The adhering conditions were a pressing pressure of 30 kgf/cm², a pressing time of 45 minutes, and a pressing temperature of 370 °C.

### [Examples 2 to 30]

A layer of adhesive was formed in the same manner as in Example 1, except that an aqueous solution of the compounds (B-1 to 6) and compounds (C-1 to 9) shown in Table 1 was used as an adhesive to form a layer of adhesive on one surface of the metal material (D-1, 2) shown in Table 1. When the solubility of compound (B) and compound (C) was low and the compound concentration in the aqueous solution could not be increased, the adhesion amount shown in Table 1 was obtained by, for example, increasing the mesh of the bar used for bar coating or applying an additional coat to the dried layer of the adhesive. Thereafter, a metal-clad laminate was manufactured in the same manner as in Example 1, except that the adhesion was carried out under the conditions of the pressing time and pressing temperature shown in Table 1.

### [Examples 31 to 36]

A metal-clad laminate was manufactured in the same manner as in Example 1 except that a layer of adhesive was formed using an aqueous solution of the compound (B-1, C-8) shown in Table 1 as the adhesive and adhesion was performed under the conditions of the pressing time and pressing pressure shown in Table 1.

### [Examples 37 and 38]

A metal-clad laminate was manufactured in the same manner as in Example 1, except that a layer of adhesive was formed using an aqueous solution of the compounds (B-1, C-8) shown in Table 1 as the adhesive, and the resin material (E-2) shown in Table 1 was used for adhesion under the conditions of pressing time, pressing temperature, and pressing pressure shown in Table 1.

### [Examples 39 and 40]

A metal-clad laminate was manufactured in the same manner as in Example 1 except that a layer of adhesive was formed using the compound (B-1, C-8) shown in Table 1 was used as the adhesive, and the metal material (D-3) shown in Table 1 was used for adhesion.

### [Comparative Examples 1 to 3, 9, 16, and 28]

A metal-clad laminate was manufactured in the same manner as in Example 1, except that no layer of adhesive was formed and that the metal materials (D-1 to D-4), low dielectric resin materials (E-1, 2) or resin material I-1 shown in Table 2 were used for the pressing time and pressing temperature conditions shown in Table 2.

### [Comparative Examples 4 to 8]

A metal-clad laminate was manufactured in the same manner as in Example 1, except that a layer of adhesive was formed using an aqueous solution of the compounds (F-1 to F-5) shown in Table 2 was used as the adhesive.

### [Comparative Examples 10 to 15]

A metal-clad laminate was manufactured in the same manner as in Example 1, except that a layer of adhesive was formed using an aqueous solution of the water-based resin (G-1 to 6) shown in Table 2 as the adhesive.

### [Comparative Examples 17 and 18]

A metal-clad laminate was manufactured in the same manner as in Example 1, except that a layer of adhesive was formed using an aqueous solution of the compounds (B-1, C-8) shown in Table 2 as the adhesive, and the resin material I-1 was used for adhesion under the conditions of pressing time and pressing temperature shown in Table 2.

### [Comparative Example 19]

A metal-clad laminate was manufactured in the same manner as in Example 1, except that a layer of adhesive of 10 g/m² was formed using epoxy adhesive H-1 (ThreeBond (Registered trademark) 2086M main agent (epoxy resin) / curing agent (polythiol)) as the adhesive, and without drying, the layer was placed on a resin material under the conditions of pressing time and pressing temperature shown in Table 2.

### [Comparative Example 20]

jER828EL (epoxy compound) was diluted with toluene, and pentaethylenehexamine (amine curing agent) was added and stirred until it became homogeneous so that the molar ratio of the epoxy group : the number of active hydrogen atoms in the amino group was 1.2 : 1.0. This toluene solution was used as the adhesive and was applied (by bar coating) to one surface of the copper foil. Thereafter, the copper foil was dried in a hot air circulating drying oven at 40 °C for 3 minutes, and a metal-clad laminate was manufactured in the same manner as in Example 1, except that a layer of adhesive was formed on the copper foil surface. In addition, the concentration upon dilution was adjusted so that the layer of the adhesive formed on the copper foil surface would have a deposition amount of 106 mg/m². At this time, the deposition amount of pentaethylenehexamine alone in the total deposition amount of the layer of the adhesive was 12 mg/m².

### [Comparative Example 21]

A metal-clad laminate was manufactured in the same manner as in Comparative Example 20, except that the concentration was adjusted so that the layer of the adhesive formed on the copper foil surface had a deposition amount of 1762 mg/m². At this time, the deposition amount of pentaethylenehexamine alone in the total deposition amount of the layer of the adhesive was 200 mg/m².

### [Comparative Example 22]

A metal-clad laminate was manufactured in the same manner as in Comparative Example 20, except that Epomin SP-006 was used as the amine curing agent and a layer of adhesive was formed on the copper foil surface so as to achieve the deposition amount shown in Table 2. At this time, the deposition amount of Epomin SP-006 alone in the total deposition amount of the layer of the adhesive was 12 mg/m².

### [Comparative Example 23]

A metal-clad laminate was manufactured in the same manner as in Comparative Example 20, except that Denacol EX313 was used as the epoxy compound and a layer of adhesive was formed on the copper foil surface so as to have the deposition amount shown in Table 2. At this time, the deposition amount of pentaethylenehexamine alone in the total deposition amount of the layer of the adhesive was 12 mg/m².

### [Comparative Examples 24 to 27]

A metal-clad laminate was manufactured in the same manner as in Example 1 except that a layer of adhesive was formed using an aqueous solution of the compounds (B-1, C-8) shown in Table 2 as the adhesive, and materials (J-1, 2) other than resin were used.

### [Ten-point mean roughness (Rzjis) of metal material surface]

The ten-point mean roughness (Rzjis) and arithmetic mean roughness (Ra) of the adhering surface of the metal materials (D-1 to D-4) used above with the resin were measured in accordance with JIS B0601: 2001 using a laser microscope (Keyence Corporation VK-X1000). The detailed measurement method is described below. Note that the measurement environment temperature using the laser microscope was set to 23 to 25 °C.
(1) Place the measurement sample on the stage with the metal material surface to be measured for roughness facing up.
(2) Adjust the focus with a 50× objective lens and take an image in shape measurement mode. To take the image, select [Basic Settings] and set [Scan Mode: Laser Confocal], [Measurement Size: Standard], and [Measurement Quality: High Precision].
(3) The measurement target area is the imaged 202 µm × 270 µm (magnification on the monitor is 1200 times), and the surface roughness is measured within this range.
(4) Start the [Multi-file analysis application VK-X], select [Image processing], and correct the surface.
(5) For surface roughness, select [Line roughness] and display five horizontal and five vertical lines at arbitrary different locations within the surface image, and obtain the ten-point mean roughness Rzjis and arithmetic mean roughness Ra values for each. At this time, the cutoff value of each contour curve filter was set to λc = 0.25 µm.
(6) The average values of the obtained 10 numerical values are calculated to obtain the ten-point mean roughness Rzjis and the arithmetic mean roughness Ra.

The deposition amount of the layer of the adhesive was determined using the following method. The amount of carbon in the liquid adhesive was measured using a TOC meter (Total Organic Carbon Analyzer ON-LINE TOC-VCSH, manufactured by Shimadzu Corporation), and the proportion of carbon in the solids was calculated using the method described above. A coating film was formed on the metal material used in each of the examples and comparative examples using the aqueous adhesive solution by bar coating, and then dried at 100 °C for 1 minute in a hot air circulation drying oven to form a dry coating film. The copper foil on which the above-mentioned dried coating film was formed was cut into two pieces of 1 cm width × 3 cm length as measurement samples, and analyzed with a total organic carbon analyzer TOC-5000A (manufactured by Shimadzu Corporation) to measure the amount of carbon per unit area. Since the amount of carbon per unit area can be used to calculate the deposition amount per unit area using the method described above, the solid content concentration of the adhesive that would give the deposition amount shown in Table 1 was determined, and a metal-clad laminate having a layer of adhesive for adhesion evaluation was prepared. Note that if the solubility of the adhesive component was low and the desired deposition amount could not be obtained by forming a coating film using the bar coating method once, the coating film was formed using the bar coating method repeatedly, and the deposition amount was calculated using a TOC meter similar to that described above, and after confirming that the desired deposition amount was obtained, a metal-clad laminate for adhesion evaluation was prepared. In the same manner as above, for each of the other adhesives, the solid content concentration of the adhesive was determined using a TOC meter so that the layer of the adhesive formed on the surface of each metal material had the deposition amount shown in Tables 1 and 2. Note that the solid content concentration was determined for each combination of the compound and metal material used to form the layer of the adhesives shown in Tables 1 and 2.

### [Evaluation of ignition residue]

The ignition residues of the compounds (B) and (C) used in the above Examples were measured by the following procedure.
(1) A measurement sample was prepared as a 1% by mass solution in deionized water.
(2) The weight m (approximately 25 g) of a PFA petri dish was measured using an electronic balance capable of measuring in grams to four decimal places.
(3) The solution diluted in (1) was dripped onto the petri dish, and the weight n (approximately 5 g) of the dripped solution was measured.
(4) The petri dish was placed in a stainless steel tray, the opening was covered with aluminum foil, and several holes with a diameter of about 1 cm were made to allow volatile components to escape, and the petri dish was then placed in a hot air circulating drying oven and heated at 265 °C for 1 hour.
(5) After (4), the petri dish was taken out and allowed to cool until the sample temperature reached 30 °C, and after cooling, the weight M of the dish was measured.
(6) The ignition residue was measured using the above-described formula (i).
(7) The above measurement was carried out four times, and the arithmetic mean value was used as the evaluation value.
(8) The evaluation values calculated in (7) were rated according to the following criteria. The results are shown in Table 1.
   D: Ignition residue is 0% or more but less than 10%
   C: Ignition residue is 10% or more but less than 20%
   B: Ignition residue is 20% or more but less than 30%
   A: Ignition residue is 30% or more

### < Evaluation of adhesiveness >

The metal-clad laminates using the metal materials (D-1), (D-2) and (D-4) prepared in the above Examples and Comparative Examples were cut to a width of 0.3 cm and a length of 7 cm, and the peel strength was measured when the tip of the metal material layer was gripped and pulled with a jig of a tensile tester. Specifically, the peel strength (peel strength) was plotted in 0.1 mm increments over the length (12.5mm) from 2.75 mm as the starting point to 15.25 mm as the end point among the peel length (the length perpendicular to the width of the cut metal-clad laminate), and the arithmetic mean was used as the evaluation value. Other than these, the peel strength of the metal material in the 90° direction was measured in accordance with JIS C5012: 1993, and the adhesiveness was evaluated according to the following evaluation criteria. For the metal-clad laminate using the metal material (D-3), the peel strength was measured in the same manner as described above, except that the tip of the laminated portion of the resin material layer and the ground layer was gripped with the jig of the tensile tester, and the adhesion was evaluated. Note that, in this evaluation, taking into consideration the adhesiveness when no adhesive was used, metal materials (D-1), (D-2) and (D-4) with a rating of 2 or less were evaluated as having poor adhesiveness, and metal material (D-3) with a rating of 4 or less was evaluated as having poor adhesiveness. Furthermore, since the resin material layer underwent cohesive failure at 10.0 N or more using a tensile tester, making measurement difficult, a test was further conducted in which the metal material was peeled off in a 90° direction for metal materials (D-1), (D-2), and (D-4), or a layer in which the resin material and ground layer were adhered for metal material (D-3) was peeled off with fingers at a speed of approximately 600 mm/min. The rating was based on the degree of spread of the resin material on the metal surface after peeling. The results are shown in Tables 1 and 2.

### [Evaluation criteria: peel strength and appearance of metal material surface after peeling]

1 point: 0 N/cm or more but less than 1.0 N/cm
2 points: 1.0 N/cm or more but less than 2.5 N/cm
3 points: 2.5 N/cm or more but less than 5.0 N/cm
4 points: 5.0 N/cm or more but less than 7.5 N/cm
5 points: 7.5 N/cm or more but less than 10.0 N/cm
6 points: 10.0 N/cm or more, and the area of the cohesively failed resin material spread on the metal surface after peeling was 20% or more but less than 40% of the area of the metal surface. 7 points: 10.0 N/cm or more, and the area of the cohesively failed resin material spread on the metal surface after peeling was 40% or more but less than 70% of the area of the metal surface. 8 points: 10.0 N/cm or more, and the area of the cohesively failed resin material spread on the metal surface after peeling was 70% or more of the area of the metal surface.

**Table 1**

| No. | Compound used in adhesive | Residue at 265 °C | Amine compound percentage in adhesive (% by mass) | Metal material | Resin material | Pressing time (min) | Pressing temperature (°C) | Pressing pressure (kgf/cm²) | Deposition amount | Adhesiveness |
|---|---|---|---|---|---|---|---|---|---|---|
| 1 | B-1 | A | 100 | D-1 | E-1 | 45 | 370 | 30 | 12 mg/m² | 8 |
| 2 | B-2 | C | 100 | D-1 | E-1 | 45 | 370 | 30 | 12 mg/m² | 4 |
| 3 | B-3 | A | 100 | D-1 | E-1 | 45 | 370 | 30 | 12 mg/m² | 5 |
| 4 | B-4 | A | 100 | D-1 | E-1 | 45 | 370 | 30 | 12 mg/m² | 8 |
| 5 | B-5 | D | 100 | D-1 | E-1 | 45 | 370 | 30 | 12 mg/m² | 3 |
| 6 | B-6 | B | 100 | D-1 | E-1 | 45 | 370 | 30 | 12 mg/m² | 5 |
| 7 | C-1 | D | 100 | D-1 | E-1 | 45 | 370 | 30 | 12 mg/m² | 3 |
| 8 | C-2 | C | 100 | D-1 | E-1 | 45 | 370 | 30 | 12 mg/m² | 4 |
| 9 | C-3 | B | 100 | D-1 | E-1 | 45 | 370 | 30 | 12 mg/m² | 5 |
| 10 | C4 | A | 100 | D-1 | E-1 | 45 | 370 | 30 | 12 mg/m² | 6 |
| 11 | C-5 | A | 100 | D-1 | E-1 | 45 | 370 | 30 | 12 mg/m² | 6 |
| 12 | C6 | A | 100 | D-1 | E-1 | 45 | 370 | 30 | 12 mg/m² | 8 |
| 13 | C-7 | A | 100 | D-1 | E-1 | 45 | 370 | 30 | 12 mg/m² | 8 |
| 14 | C-8 | A | 100 | D-1 | E-1 | 45 | 370 | 30 | 12 mg/m² | 8 |
| 15 | C-9 | A | 100 | D-1 | E-1 | 45 | 370 | 30 | 12 mg/m² | 8 |
| 16 | B-1 | A | 100 | D-1 | E-1 | 45 | 370 | 30 | 5 mg/m² | 3 |
| 17 | C-8 | A | 100 | D-1 | E-1 | 45 | 370 | 30 | 5 mg/m² | 3 |
| 18 | B-1 | A | 100 | D-1 | E-1 | 45 | 370 | 30 | 100 mg/m² | 8 |
| 19 | B-1 | A | 100 | D-1 | E-1 | 45 | 370 | 30 | 500 mg/m² | 8 |
| 20 | B-1 | A | 100 | D-1 | E-1 | 45 | 370 | 30 | 1000 mg/m² | 8 |
| 21 | B-1 | A | 100 | D-1 | E-1 | 45 | 370 | 30 | 2000 mg/m² | 4 |
| 22 | B-1 | A | 100 | D-1 | E-1 | 45 | 370 | 30 | 4000 mg/m² | 4 |
| 23 | B-1 | A | 100 | D-1 | E-1 | 45 | 370 | 30 | 7000 mg/m² | 3 |
| 24 | C-8 | A | 100 | D-1 | E-1 | 45 | 370 | 30 | 100 mg/m² | 8 |
| 25 | C-8 | A | 100 | D-1 | E-1 | 45 | 370 | 30 | 500 mg/m² | 6 |
| 26 | C-8 | A | 100 | D-1 | E-1 | 45 | 370 | 30 | 1000 mg/m² | 6 |
| 27 | C-8 | A | 100 | D-1 | E-1 | 45 | 370 | 30 | 2000 mg/m² | 5 |
| 28 | C-8 | A | 100 | D-1 | E-1 | 45 | 370 | 30 | 4000 mg/m² | 4 |
| 29 | B-1 | A | 100 | D-2 | E-1 | 45 | 370 | 30 | 12 mg/m² | 8 |
| 30 | C-8 | A | 100 | D-2 | E-1 | 45 | 370 | 30 | 12 mg/m² | 8 |
| 31 | B-1 | A | 100 | D-1 | E-1 | 10 | 370 | 30 | 12 mg/m² | 6 |
| 32 | C-8 | A | 100 | D-1 | E-1 | 10 | 370 | 30 | 12 mg/m² | 6 |
| 33 | B-1 | A | 100 | D-1 | E-1 | 135 | 370 | 30 | 12 mg/m² | 8 |
| 34 | C-8 | A | 100 | D-1 | E-1 | 135 | 370 | 30 | 12 mg/m² | 8 |
| 35 | B-1 | A | 100 | D-1 | E-1 | 45 | 370 | 17 | 12 mg/m² | 8 |
| 36 | C-8 | A | 100 | D-1 | E-1 | 45 | 370 | 17 | 12 mg/m² | 8 |
| 37 | B-1 | A | 100 | D-1 | E-2 | 20 | 300 | 30 | 12 mg/m² | 3 |
| 38 | C-8 | A | 100 | D-1 | E-2 | 20 | 300 | 30 | 12 mg/m² | 5 |
| 39 | B-1 | A | 100 | D-3 | E-1 | 45 | 370 | 30 | 750 mg/m² | 8 |
| 40 | C-8 | A | 100 | D-3 | E-1 | 45 | 370 | 30 | 750 mg/m² | 8 |

**Table 2**

| No. | Compound used in adhesive | Amine compound percentage in adhesive (% by mass) | Metal material | Resin material or material other than resin | Pressing time (min) | Pressing temperature (°C) | Pressing pressure (kgf/cm²) | Deposition amount | Adhesiveness |
|---|---|---|---|---|---|---|---|---|---|
| 1 | - | - | D-1 | E-1 | 45 | 370 | 30 | - | 1 |
| 2 | - | - | D-1 | E-2 | 20 | 300 | 30 | - | 1 |
| 3 | - | - | D-2 | E-1 | 45 | 370 | 30 | - | 1 |
| 4 | F-1 | - | D-1 | E-1 | 45 | 370 | 30 | 12 mg/m² | 2 |
| 5 | F-2 | - | D-1 | E-1 | 45 | 370 | 30 | **12** mg/m² | 1 |
| 6 | F-3 | - | D-1 | E-1 | 45 | 370 | 30 | 12 mg/m² | 1 |
| 7 | F-4 | - | D-1 | E-1 | 45 | 370 | 30 | 18 mg/m² | 1 |
| 8 | F-5 | - | D-1 | E-1 | 45 | 370 | 30 | **12** mg/m² | 2 |
| 9 | - | - | D-4 | E-1 | 45 | 370 | 30 | - | 1 |
| 10 | G-1 | - | D-1 | E-1 | 45 | 370 | 30 | 40 mg/m² | 1 |
| 11 | G-2 | - | D-1 | E-1 | 45 | 370 | 30 | 40 mg/m² | 1 |
| 12 | G-3 | - | D-1 | E-1 | 45 | 370 | 30 | 40 mg/m² | 2 |
| 13 | G-4 | - | D-1 | E-1 | 45 | 370 | 30 | 25 mg/m² | 1 |
| 14 | G-5 | - | D-1 | E-1 | 45 | 370 | 30 | 40 mg/m² | 1 |
| 15 | G-6 | - | D-1 | E-1 | 45 | 370 | 30 | 40 mg/m² | 2 |
| 16 | - | - | D-1 | I-1 | 60 | 175 | 30 | - | 3 |
| 17 | B-1 | 100 | D-1 | I-1 | 60 | 175 | 30 | 12 mg/m² | 2 |
| 18 | C-8 | 100 | D-1 | I-1 | 60 | 175 | 30 | 12 mg/m² | 2 |
| 19 | H-1 | - | D-1 | E-1 | 120 | 30 | 30 | 10 g/m² | 1 |
| 20 | H-2 | 11 | D-1 | E-1 | 45 | 370 | 30 | 106 mg/m² | 1 |
| 21 | H-2 | 11 | D-1 | E-1 | 45 | 370 | 30 | 1762 mg/m² | 1 |
| 22 | H-3 | 11 | D-1 | E-1 | 45 | 370 | 30 | 107 mg/m² | 1 |
| 23 | H-4 | 15 | D-1 | E-1 | 45 | 370 | 30 | 82 mg/m² | 1 |
| 24 | B-1 | 100 | D-1 | J-1 | 45 | 370 | 30 | 12 mg/m² | 1 |
| 25 | C-8 | 100 | D-1 | J-1 | 45 | 370 | 30 | 12 mg/m² | 1 |
| 26 | B-1 | 100 | D-1 | J-2 | 45 | 370 | 30 | 12 mg/m² | 1 |
| 27 | C-8 | 100 | D-1 | J-2 | 45 | 370 | 30 | 12 mg/m² | 1 |
| 28 | - | - | D-3 | E-1 | 45 | 370 | 30 | - | 4 |

## Claims

1. An adhesive for adhering a metal material and a low dielectric resin material, the adhesive comprising an organic amine compound (A) as a main component, wherein the organic amine compound (A) comprises at least one selected from a compound (B) having an amino group directly bonded to a nitrogen-containing aromatic ring and a compound (C) having a polyalkylamine skeleton.

2. The adhesive according to claim 1, wherein a mass proportion of the organic amine compound (A) in a nonvolatile content of the adhesive is 20% by mass to 100% by mass.

3. A laminate comprising, in this order: a metal material layer; an adhesive layer formed from the adhesive according to claim 1 or 2; and a low dielectric resin material layer.

4. The laminate according to claim 3, wherein for surfaces of the metal material layer, a ten-point mean roughness (Rzjis) of at least a surface that is adhered to the low-dielectric resin material layer is 2.5 µm or less.

5. The laminate according to claim 3, wherein a dielectric loss tangent of a low dielectric resin material constituting the low dielectric resin material layer is 0.0001 to 0.01 at a temperature of 23 °C and 10 GHz.

6. A printed wiring board obtained by processing the metal material layer of the laminate according to claim 3 into a wiring circuit.

7. The printed wiring board according to claim 6, which is used for signals having a frequency of 25 GHz or more.

8. An electronic device comprising the printed wiring board according to claim 6.

9. A method for manufacturing a laminate, comprising adhering a metal material and a low dielectric resin material together with the adhesive according to claim 1 sandwiched therebetween.

10. A method for manufacturing a laminate, comprising:
a step of contacting the adhesive of claim 1 with a metal material to form a layer of the adhesive on the metal material;
optionally, after the step of contacting, a step of drying the layer of the adhesive; and
a step of contacting a low dielectric resin material with a surface of the layer of the adhesive and then applying heat and pressure.

11. The method for manufacturing a laminate according to claim 10, wherein a deposition amount of the layer of the adhesive applied per unit area is 0.1 to 4000 mg/m².
